# EUROPEAN PATENT APPLICATION

(11) **EP 4 703 714 A1**
(43) Date of publication of application: **04.03.2026**
(21) Application number: 23935365.9
(22) Date of filing: 28.04.2023
(51) Int. Cl.: G01N 24/00

(54) **NUCLEAR MAGNETIC RESONANCE SENSING DEVICE AND NUCLEAR MAGNETIC RESONANCE SENSING METHOD**

(71) Applicant: Sumida Corporation, Tokyo 100-0042 (JP); Kyoto University, Kyoto-shi, Kyoto 606-8501 (JP)
(72) Inventor: YOSHII Yoshiharu, Natori City, Miyagi 981-1226 (JP); SAKO Akifumi, Natori City, Miyagi 981-1226 (JP); HAMADA Shingo, Natori City, Miyagi 981-1226 (JP); MIZUOCHI Norikazu, Kyoto-shi, Kyoto 606-8501 (JP); OHKI Izuru, Kyoto-shi, Kyoto 606-8501 (JP)
(74) Representative: Winter, Brandl - Partnerschaft mbB
(86) International application number: PCT/JP2023/016805
(87) International publication number: WO 2024/224587

(57) **Abstract**

A nuclear magnetic resonance sensing part 1 applies a high frequency magnetic field based on an RF signal to a target object and generates an observation signal with a frequency that is shifted from a frequency of the RF signal by a frequency of an NMR signal. A mixer part 6 generates an IF demodulation signal including the NMR signal. A low-pass filter 7 passes a low frequency component of the IF demodulation signal. In a digitizing device 21, a physical field generator generates a magnetic field and so on corresponding to the IF demodulation signal that has passed through the low-pass filter 7, an optical quantum sensor part generates light corresponding to the magnetic field and so on by a sensing member and converts the light into a sensor signal by a photoelectric element, and an analog/digital converter digitizes the sensor signal. The optical quantum sensor part performs a quantum operation with respect to the sensing member and causes the sensing member to generate the light corresponding to the magnetic field and so on.

## Description

### TECHNICAL FIELD

The present invention relates to a nuclear magnetic resonance sensing device and a nuclear magnetic resonance sensing method.

### BACKGROUND ART

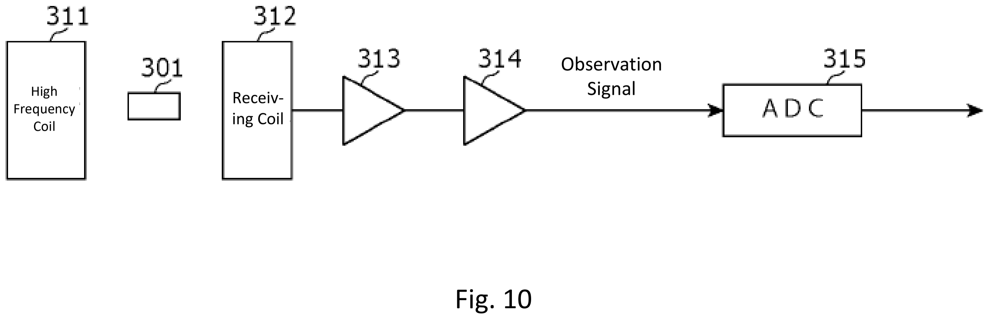

Fig. 10 is a block diagram that shows an example of a measurement device using nuclear magnetic resonance. As shown in, for instance, Fig. 10, in general, the measurement device using nuclear magnetic resonance: (a) makes nuclear magnetization resonate by applying a high frequency magnetic field based on an RF (Radio Frequency) signal having a frequency close to a precession frequency with a high frequency coil 311 with respect to a measuring object 301; (b) detects the resonated nuclear magnetization with a receiving coil 312 and generates an observation signal including a nuclear magnetic resonance (NMR) signal; (c) amplifies the observation signal by preamplifiers 313 and 314 such as a low noise amplifier (LNA); and (d) detects the amplified observation signal by a detector so as to extract the NMR signal.

Further, in general, such observation signals and NMR signals are converted from analog signals to digital signals by an analog/digital conversion circuit 315 and are supplied to a post-stage arithmetic processing device as digital signals (for instance, refer to Patent Documents 1 and 2).

### PRIOR ART DOCUMENTS

### PATENT DOCUMENTS

Patent Document 1: Japanese Patent Publication Number 2008-039641.
Patent Document 2: Japanese Patent Publication Number 2011-101776.

### SUMMARY OF THE INVENTION

### PROBLEMS TO BE SOLVED BY THE INVENTION

However, in the above-mentioned device, because an amplifier circuit such as a preamplifier is provided in order to amplify the observation signal, noise being peculiar to the amplifier circuit is superposed on the observation signal and the NMR signal. For this reason, the NMR signals with a level similar to or lower than the noise floor of the amplifier circuit are buried in noise, and it is difficult to accurately detect such the low-level NMR signals.

The present invention has an object that is to obtain a nuclear magnetic resonance sensing device and a nuclear magnetic resonance sensing method that can accurately detect a low-level NMR signal and have high resolution in view of the above-described problems.

### MEANS FOR SOLVING THE PROBLEMS

A nuclear magnetic resonance sensing device according to the present invention includes a nuclear magnetic resonance sensing part that applies an RF signal to a target object and generates an observation signal with a frequency that is shifted from a frequency of the RF signal by a frequency of a nuclear magnetic resonance signal, a mixer part that performs intermediate frequency demodulation of the observation signal and generates an intermediate frequency demodulation signal including the nuclear magnetic resonance signal, a low-pass filter that attenuates a high frequency band component among two band components obtained by the intermediate frequency demodulation of the intermediate frequency demodulation signal and passes a low frequency band component among two band components, and a digitizing device that digitizes the intermediate frequency demodulation signal that has passed through the low-pass filter. The digitizing device includes a physical field generator that generates a magnetic field or an electric field corresponding to the intermediate frequency demodulation signal that has passed through the low-pass filter, an optical quantum sensor part that generates light corresponding to the magnetic field or the electric field by a sensing member and converts the light into an electrical signal as a sensor signal by a photoelectric element, and an analog/digital converter that digitizes the sensor signal. The optical quantum sensor part performs a quantum operation with respect to the sensing member and causes the sensing member to generate the light corresponding to the magnetic field or the electric field.

A nuclear magnetic resonance sensing method includes a step of applying an RF signal to a target object and generating an observation signal with a frequency that is shifted from a frequency of the RF signal by a frequency of a nuclear magnetic resonance signal, a step of performing intermediate frequency demodulation of the observation signal and generating an intermediate frequency demodulation signal including the nuclear magnetic resonance signal, a step of attenuating, by a low-pass filter, a high frequency band component among two band components obtained by the intermediate frequency demodulation of the intermediate frequency demodulation signal and passing a low frequency band component among two band components, and a digitizing step of digitizing, by a digitizing device, the intermediate frequency demodulation signal that has passed through the low-pass filter. The digitizing step includes (a) generating a magnetic field or an electric field corresponding to the intermediate frequency demodulation signal that has passed through the low-pass filter, (b) generating light corresponding to the magnetic field or the electric field by a sensing member, (c) converting the light into an electrical signal as a sensor signal by a photoelectric element, and (d) digitizing the sensor signal by an analog/digital converter. In the digitizing step, a quantum operation with respect to the sensing member is performed, and the sensing member is caused to generate the light corresponding to the magnetic field or the electric field.

### EFFECTS OF THE INVENTION

According to the present invention, it is possible to obtain a nuclear magnetic resonance sensing device and a nuclear magnetic resonance sensing method that can accurately detect a low-level NMR signal and have high resolution.

### BRIEF DESCRIPTION OF THE DRAWINGS

[Fig. 1] Fig. 1 is a block diagram that shows a configuration of a nuclear magnetic resonance sensing device according to an embodiment of the present invention.
[Fig. 2] Fig. 2 is a block diagram that shows a configuration of a digitizing device 21 in Fig. 1.
[Fig. 3] Fig. 3 is a diagram that shows a configuration of a sensor body 51 in the digitizing device according to a first embodiment.
[Fig. 4] Fig. 4 is a diagram that explains an example of a sensor signal in the digitizing device according to the first embodiment.
[Fig. 5] Fig. 5 is a circuit diagram that shows a configuration of a mixer part 6 in Fig. 1.
[Fig. 6] Fig. 6 is a circuit diagram that shows a configuration of a transformer 9 in Fig. 2.
[Fig. 7] Fig. 7 is a diagram that explains an example of a band-pass filter characteristic of the transformer 9 shown in Fig. 6.
[Fig. 8] Fig. 8 is a circuit diagram that shows a configuration of a mixer part 6 in a second embodiment.
[Fig. 9] Fig. 9 is a diagram that shows a configuration of a sensor body 51 in a digitizing device according to a third embodiment.
[Fig. 10] Fig. 10 is a block diagram that shows an example of a measurement device using the nuclear magnetic resonance.

### EMBODIMENTS FOR CARRYING OUT THE INVENTION

Embodiments of the present invention will be explained below with reference to the drawings.

### FIRST EMBODIMENT

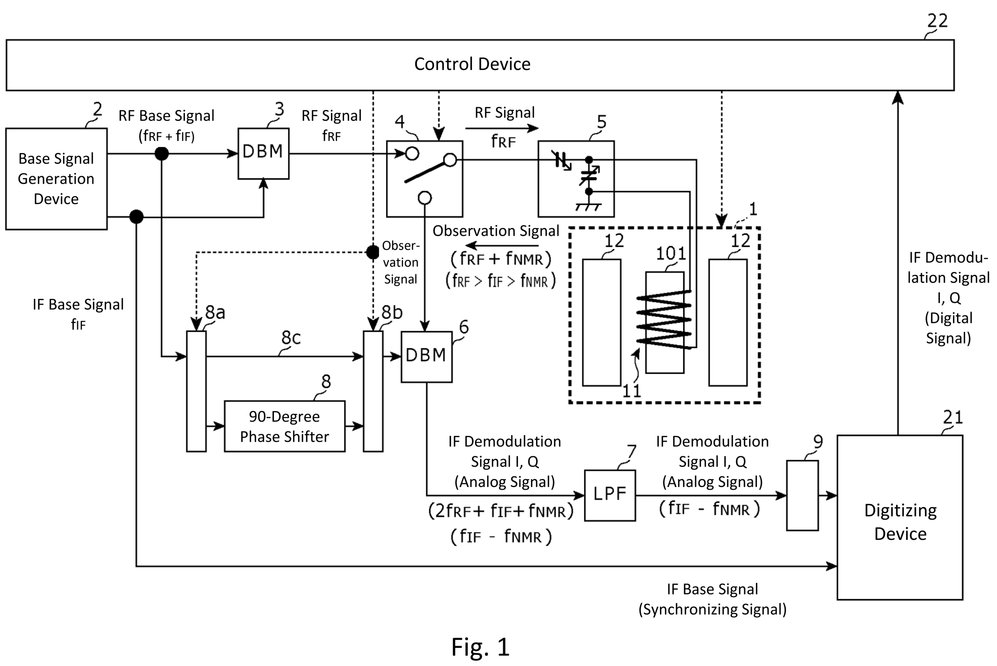

Fig. 1 is a block diagram that shows a configuration of a nuclear magnetic resonance sensing device according to an embodiment of the present invention. The nuclear magnetic resonance sensing device is used for, for instance, a molecular structure analysis and imaging of a target object.

The nuclear magnetic resonance sensing device shown in Fig. 1 has a nuclear magnetic resonance sensing part 1, a base signal generation device 2, a mixer part 3, a switching part 4, a matching/tuning circuit 5, a mixer part 6, and a low-pass filter 7.

The nuclear magnetic resonance sensing part 1 applies an RF signal described below to a target object and generates an observation signal (an analog electrical signal) with a frequency (f_{RF} + f_{NMR}) that is shifted from a frequency f_{RF} of the RF signal by a frequency f_{NMR} of a nuclear magnetic resonance (NMR) signal.

Specifically, the nuclear magnetic resonance sensing part 1 has a coil 11 and a magnet part 12. The coil 11 applies a high frequency magnetic field based on the RF signal to the target object 101, senses a magnetic field change based on movement (motion) of nuclear magnetization in the target object 101, and outputs an observation signal. The magnet part 12 is a permanent magnet or an electromagnet and applies a static magnetic field or a gradient magnetic field to the target object 101. This observation signal includes the NMR signal and has the frequency (f_{RF} + f_{NMR}) that is the sum of the frequency f_{NMR} and the RF signal frequency f_{RF}.

The base signal generation device 2 generates and outputs an intermediate frequency (IF) base signal having a single intermediate frequency f_{IF} and an RF base signal having a single frequency that is the sum of the frequency f_{RF} of the RF band and the intermediate frequency f_{IF}.

The mixer part 3 mixes the RF base signal and the IF base signal and generates the RF signal having the frequency f_{RF}. Further, the mixer part 3 performs SSB (Single Side Band) modulation and outputs only the RF signal of the frequency f_{RF} among two frequency components of (f_{RF} + 2f_{IF}) and f_{RF} that are obtained by the mixing without outputting the component of the frequency (f_{RF} + 2f_{IF}). Here, the mixer part 3 is a Double Balanced Mixer (DBM) that is configured with two phase distributors and a diode bridge.

The switching part 4 switches a connection destination for a side of the nuclear magnetic resonance sensing part 1 (the nuclear magnetic resonance sensing part via the matching/tuning circuit 5) from one of a transmission system of the RF signal (the base signal generation device 2 and the mixer part 3) and a reception system of the observation signal (the base signal generation device 2, the mixer part 6, and the low-pass filter 7) to the other. Specifically, when transmitting the RF signal, the switching part 4 electrically connects the transmission system to the side of the nuclear magnetic resonance sensing part 1, and when receiving the observation signal, the switching part 4 electrically connects the reception system to the side of the nuclear magnetic resonance sensing part 1.

The matching/tuning circuit 5 is a circuit that performs an impedance matching so as to suppress a reflection of the RF signal at the nuclear magnetic resonance sensing part 1, and at the same time, performs a frequency tuning so as to improve a level of the NMR signal.

The mixer part 6 mixes the observation signal and the RF base signal, performs intermediate frequency (IF) demodulation, and generates and outputs an intermediate frequency (IF) demodulation signal having two frequency components of (2f_{RF} + f_{IF} + f_{NMR}) and (f_{IF} - f_{NMR}).

For instance, the mixer part 6 is a DBM that is configured with a diode and a phase distributor and does not include an active element such as a transistor.

The low-pass filter 7 attenuates a high frequency band component (2f_{RF} + f_{IF} + f_{NMR}) among two band components of (2f_{RF} + f_{IF} + f_{NMR}) and (f_{IF} - f_{NMR}) that are obtained by the IF demodulation by the mixer part 6 of the above-mentioned IF demodulation signal and is a filter that passes a low frequency band component (f_{IF} - f_{NMR}) among two band components. Further, the low-pass filter 7 is an analog filter that is configured with only passive elements, such as a capacitor, an inductor, or a resistor.

Further, in this embodiment, the nuclear magnetic resonance sensing device shown in Fig. 1 has a 90-degree phase shifter 8 and phase switching parts 8a and 8b.

The 90-degree phase shifter 8 shifts a phase of the RF base signal by 90 degrees. Further, the 90-degree phase shifter 8 may be an analog circuit and may not include any active elements. The phase switching parts 8a and 8b are two switches that are switched in conjunction with each other, and depending on the state of the phase switching parts 8a and 8b, either the RF base signal that is not phase-shifted by 90 degrees or the RF base signal that is phase-shifted by 90 degrees is input to the mixer part 6.

Further, the nuclear magnetic resonance sensing device shown in Fig. 1 has a digitizing device 21 and a control device 22.

The digitizing device 21 converts the IF demodulation signal (the frequency component (f_{IF} - f_{NMR})) that is output from the low-pass filter 7 from an analog signal to a digital signal. Here, the IF demodulation signal is supplied to the digitizing device 21 via a transformer 9.

The control device 22 has a computer that operates according to a control program. The computer has such as a CPU (Central Processing Unit), a ROM (Read Only Memory), and a RAM (Random Access Memory) and performs operations (processes) described below by loading the control program into the RAM and executing it via the CPU. Specifically, the control device 22 controls the nuclear magnetic resonance sensing part 1 and the switching part 4 so that the nuclear magnetic resonance sensing part 1 is applied with the above-mentioned high frequency magnetic field and outputs the above-mentioned observation signal. Furthermore, the control device 22 receives the IF demodulation signal (frequency component (f_{IF} - f_{NMR})) as a digital signal from the digitizing device 21 and performs a predetermined signal processing (for instance, an extraction of the frequency component f_{NMR}) so that the frequency f_{NMR} component (that is, the NMR signal) is extracted from the IF demodulation signal (the frequency component (f_{IF} - f_{NMR})).

For instance, f_{IF} may be set to a frequency that is 1000 or more times higher than f_{NMR}, and f_{RF} may be set to a frequency that is 10 or more times higher than f_{IF}. For instance, when f_{NMR} = 1 kHz, f_{RF} = 43 MHz, and f_{IF} = 1 MHz.

Further, f_{IF} may be set to any frequency substantially within a range of 5 to 20 kHz, and f_{RF} may be set to a frequency that is 10 or more times higher than f_{IF}.

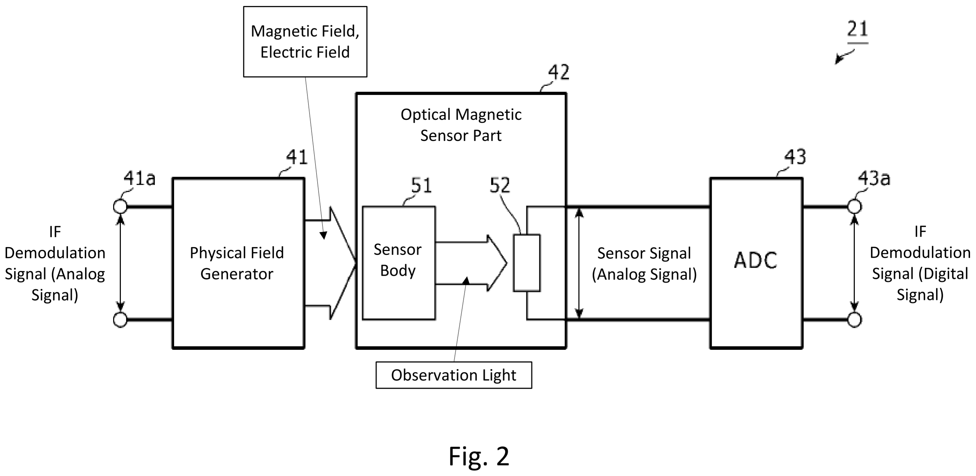

Fig. 2 is a block diagram that shows a configuration of the digitizing device 21 shown in Fig. 1. The digitizing device shown in Fig. 1 has a physical field generator 41, an optical quantum sensor part 42, and an analog/digital converter (A/D converter, ADC) 43.

The physical field generator 41 generates a magnetic field corresponding to an input signal (that is, an analog IF demodulation signal) that is input via an input terminal 41a of the physical field generator 41. For instance, the physical field generator 41 generates the magnetic field using a conductive coil or wiring.

The optical quantum sensor part 42 has a sensor body 51 and a photoelectric element 52. In the sensor body 51, a sensing member generates light (observation light) corresponding to the magnetic field that is generated by the physical field generator 41 and the photoelectric element 52 converts the light into an electrical signal as a sensor signal. The photoelectric element 52 is, for instance, a photodiode or a phototransistor and generates the sensor signal corresponding to intensity of the entered observation light.

Specifically, the optical quantum sensor part 42 (specifically, the sensor body 51) performs a quantum operation (here, a quantum operation by a microwave and a laser beam) on the sensing member so that the sensing member generates the light corresponding to the magnetic field that is generated by the physical field generator 41.

In the first embodiment, the optical quantum sensor part 42 (specifically, the sensor body 51) performs the quantum operation on the sensing member according to an optically detected magnetic resonance measuring method (ODMR) so that the sensing member generates the above-mentioned observation light.

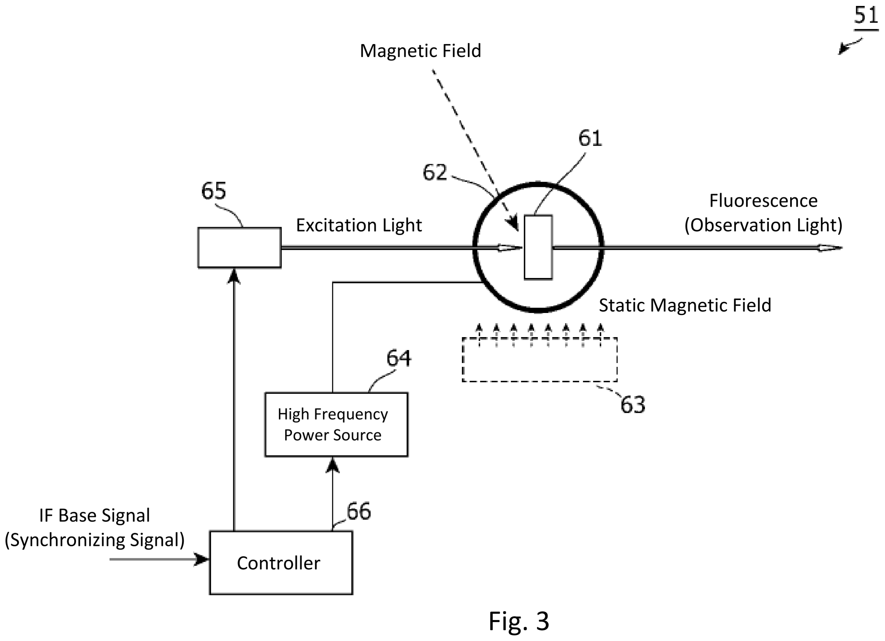

Fig. 3 is a diagram that shows the configuration of the sensor body 51 in the digitizing device according to the first embodiment. In the first embodiment, for the ODMR, as shown in, for instance, Fig. 3, the sensor body 51 has a magnetic resonance member 61 as the sensing member, a high frequency magnetic field generator 62, a magnet 63, a high frequency power source 64, a light emitting device 65, and a controller 66.

The magnetic resonance member 61 has a crystal structure. The electron spin quantum state changes in correspond with the magnetic field that is generated by the physical field generator 41, and at the same time, the magnetic resonance member 61 is a member capable of an electron spin quantum operation by a microwave (based on Rabi vibration) at a frequency that corresponds to a defect in a crystal lattice and an arrangement direction of impurities. That is, the magnetic resonance member 61 is placed within the above-mentioned magnetic field.

In this embodiment, the magnetic resonance member 61 is an optically detected magnetic resonance member having a plurality (that is, an ensemble) of specific color centers. This specific color center has an energy level capable of Zeeman splitting, and at the same time, can take a plurality of directions in which shift widths of the energy level at the time of Zeeman splitting are different from each other.

Here, the magnetic resonance member 61 is a member such as a diamond that includes a plurality of NV (Nitrogen Vacancy) centers as a specific color center of a single category (or type). In the case of the NV center, a ground state is a triplet state of ms = 0, +1, -1 and a level of ms = +1 and a level of ms = -1 undergo Zeeman splitting. When the NV center transitions from an excited state at the levels of ms = +1 and ms = -1 to the ground state, the NV center is accompanied by fluorescence at a predetermined proportion and the remaining proportion of the NV center transitions from the excited state (ms = +1 or ms = -1) to the ground state (ms = 0) with non-radiation.

Note that the color center included in the magnetic resonance member 61 may be a color center other than the NV center.

The high frequency magnetic field generator 62 applies a microwave to the magnetic resonance member 61 so as to perform an electron spin quantum operation of the magnetic resonance member 61. For instance, the high frequency magnetic field generator 62 is a plate-shaped coil and has a substantially circular coil part that emits the microwave and terminal parts that extend from both ends of the coil part and are fixed to a substrate. The high frequency power source 64 generates a current of the microwave and is conductively connected to the high frequency magnetic field generator 62. The coil part conducts two currents that are mutually in parallel at a predetermined interval so as to sandwich the magnetic resonance member 61 at both end surface parts of the coil part and emit the above-mentioned microwave. Here, the coil part is the plate-shaped coil, however, because the current of the microwave flows through the end surface part of the coil part due to a skin effect, two currents are formed. As a result, the microwave with a substantially uniform intensity is applied to the magnetic resonance member 61.

In the case of the NV center, since the color center is formed by a defect (vacancy) (V) and nitrogen (N) as an impurity in the diamond crystal, there are four possible positions for adjacent nitrogen (N) with respect to the defect (vacancy) (V) in the diamond crystal (that is, the arrangement directions of a pair of the vacancy and the nitrogen). Sub-levels (that is, the energy levels from the ground) after Zeeman splitting respectively corresponding to these arrangement directions are different from each other. Therefore, in a characteristic of a fluorescence intensity after Zeeman splitting due to a static magnetic field with respect to a frequency of the microwave, in correspond with each direction i (i = 1, 2, 3, 4), four pairs of dip frequencies (fi+, fi-) that are different from one another appear. Here, the above-mentioned frequency of the microwave (wavelength) is set in correspond with any of the dip frequencies of these four pairs of dip frequencies.

Further, the magnet 63 applies a static magnetic field (a DC magnetic field) to the magnetic resonance member 61 so that the energy levels of a plurality of specific color centers (here, a plurality of NV centers) in the magnetic resonance member 61 undergo Zeeman splitting. Here, the magnet 63 is a ring-type permanent magnet, such as a ferrite magnet, an alnico magnet, or a samarium cobalt magnet. Further, the magnet 63 may be an electromagnet.

Further, in the magnetic resonance member 61, as the arrangement direction of the above-mentioned defect and impurity is substantially coincident with the above-mentioned direction of the static magnetic field (and the direction of the applied magnetic field), the crystal of the magnetic resonance member 61 is formed and the direction of the magnetic resonance member 61 is set.

Furthermore, in this embodiment, in order to irradiate the magnetic resonance member 41 with excitation light, an optical system (not shown) from the light emitting device 65 to the magnetic resonance member 61 is provided. Further, in order to detect fluorescence (the observation light) from the magnetic resonance member 61, an optical system (not shown) from the magnetic resonance member 61 to the photoelectric element 52 is provided.

The observation light is concentrated toward the photoelectric element 52 by an optical system such as a compound parabolic concentrator (CPC). For instance, the magnetic resonance member 61 is arranged on the CPC, and among the fluorescence that is emitted in all directions from a color center in the magnetic resonance member 61, the fluorescent that is emitted in a wide solid angle (for instance, more than a predetermined percentage of all directions) by this optical system is concentrated.

The light emitting device 65 has such as a laser diode as a light source and the light source emits a laser beam (laser light) of a predetermined wavelength as excitation light to be irradiated to the magnetic resonance member 61.

According to a predetermined measurement sequence, the controller 66 (a) controls the high frequency power source 64 and the light emitting device 65, performs a quantum operation using the microwave and the laser light mentioned above, causes the sensor body 51 to generate the observation light, and causes the photoelectric element 52 to generate the sensor signal. For instance, the controller 66 has a computer that operates according to a control program. The computer has a CPU, a ROM, a RAM (Random Access Memory), etc., and performs the above-mentioned operations (or processes) by loading the control program into the RAM and executing it on the CPU. Further, the controller 66 may be built into the control device 22 or the control device 22 may operate as the controller 66. The control device 22 causes the controller 66 to repeatedly execute measurement sequences to generate the sensor signals. The measurement sequence is executed the predetermined plurality of times per period (per cycle) of the magnetic field.

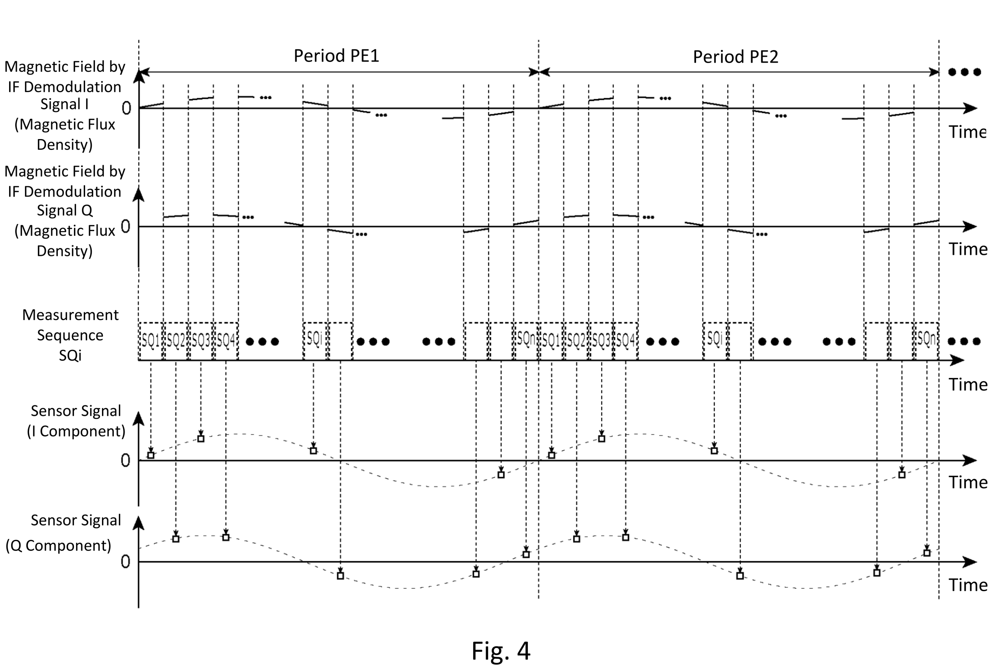

Fig. 4 is a diagram that explains an example of a sensor signal in the digitizing device according to the first embodiment. This measurement sequence is set according to such as the frequency of the above-mentioned magnetic field. For instance, when the input signal (the IF demodulation signal) is an AC signal with a relatively low frequency (for instance, several tens Hz), as shown in Fig. 4, with Ramsey pulse sequences (that is, the measurement sequences SQ1 - SQn in the DC magnetic field) during one cycle, the measurements of the above-mentioned magnetic field corresponding to the input signal is performed a plurality of times (n times), and the measured values are obtained as the sensor signals. As a result, the sensor signal at the level corresponding to the magnetic field strength at the time of each measurement sequence is generated.

Further, for instance, when the above-mentioned magnetic field is an AC magnetic field with a relatively high frequency (for instance, several tens kHz), a spin echo pulse sequence (for instance, Hahn echo sequence) may be applied to the measurement sequence. However, the measurement sequence is not limited to these sequences, and may be selected according to the frequency of the magnetic field of the measurement target. For instance, when the period of the above-mentioned magnetic field is equal to or longer than a T2 relaxation time, the magnetic field measurements are performed the plurality of times with Ramsey pulse sequences as mentioned above. When the period of the above-mentioned magnetic field is shorter than the T2 relaxation time, the spin echo pulse sequence (for instance, Hahn echo sequence) may be applied. Furthermore, when the period of the above-mentioned magnetic field is shorter than 1/2 of the T2 relaxation time, the magnetic field measurement may be performed according to a Qdyne method.

In this embodiment, the control device 22 controls the phase switching parts 8a and 8b to alternately select one of the 90-degree phase shifter 8 and a bypass wiring 8c for each measurement sequence, and alternately inputs one of the RF base signal that is not phase-shifted by 90 degrees and the RF base signal that is phase-shifted by 90 degrees to the mixer part 6 for each measurement sequence.

As a result, as shown in, for instance, Fig. 4, the sensor signal in a first phase (an I signal as an IF demodulation signal) and the sensor signal in a second phase (a Q signal as the IF demodulation signal) orthogonal to the first phase are obtained. The I signal and the Q signal are supplied to the control device 22 as signals that have been subjected to quadrature detection.

Refer back to Fig. 2, the A/D converter 43 digitizes the above-mentioned sensor signal (without digitizing the input signal). As a result, the A/D converter 43 generates a digital signal as an output signal corresponding to the input signal (IF demodulation signal) and outputs it via an output terminal 43a of the A/D converter 43.

In this embodiment, in particular, the optical quantum sensor part 42 (specifically, the sensor body 51) causes the sensing member to generate the above-mentioned observation light in a state in which the level of the sensor signal exceeds the noise floor of the A/D converter 43.

Here, the level (amplitude) of the sensor signal changes according to a factor, such as the efficiency of the sensing member (in the first embodiment, for instance, the type or the number of the color centers in the magnetic resonance member 61), the light concentration efficiency of the observation light (in the first embodiment, the amount of the entered light to the photoelectric element 52 relative to the light emission amount of the color center), or the conversion efficiency of the photoelectric element 52 (the level of the sensor signal relative to the amount of the entered light). Therefore, according to the noise floor (already known) of the A/D converter 43, the value(s) of the factor(s) is determined so that the level of the sensor signal exceeds the noise floor of the A/D converter 43. As a result, for instance, the sensitivity of the optical quantum sensor part 42 is set to 1.5 pT / Hz^{1/2} or more.

Further, in general, the noise of an A/D converter includes quantization noise and thermal noise, and in a high-resolution A/D converter, the thermal noise is more dominant than the quantization noise. The A/D converter 43 in this embodiment is a high-resolution A/D converter and the value(s) of the above-mentioned factor(s) is determined so that the level of the sensor signal exceeds the noise level of the thermal noise.

Further, a reference voltage of the A/D converter 43 is set according to a range (a minimum level value and a maximum level value) of the sensor signal. Further, by lowering the reference voltage of the A/D converter, the quantization noise is reduced, however, the thermal noise is not reduced.

Note that a level (or a range) of the IF demodulation signal being input and electromagnetic conversion efficiency of the physical field generator 41 are already known.

Furthermore, in this embodiment, in particular, the digitizing device 21 does not have an amplifier circuit, in which the sensor signal is electrically amplified, between the photoelectric element 52 and the A/D converter 43. Furthermore, in this embodiment, an amplifier circuit, in which the input signal is electrically amplified, is not provided between a signal source of the input signal and the physical field generator 41. That is, in this embodiment, an electrical amplifier circuit that is a noise source is not provided at an upstream side of the A/D converter 43. Because the thermal noise is generated and amplified in such the amplifier circuit in the same way as the A/D converter 43, the noise is superposed on a signal that is input to the A/D converter 43. Therefore, it is preferred that an amplifier circuit is not provided as mentioned above.

Further, the high frequency power source 64 and the controller 66 are electrically separated from the A/D converter 43 so as to prevent the electrical noise that is generated by the high frequency power source 64 and the controller 66 from invading (inputting) into the A/D converter 43.

Furthermore, in this first embodiment, the mixer part 6 performs intermediate frequency demodulation of the observation signal using the RF base signal so as to generate an IF demodulation signal including the NMR signal. Further, the optical quantum sensor part 42 (the controller 66) uses the IF base signal as a synchronizing signal and repeatedly and periodically performs a quantum operation with respect to the sensing member according to the synchronizing signal so that the light corresponding to the magnetic field is generated by the sensing member. As a result, the digitizing device 21 outputs a digital IF demodulation signal in synchronization with the IF base signal. Thus, the control device 22 accurately identifies the frequency f_{NMR} of the NMR signal based on this digital IF demodulation signal according to the Qdyne method.

Further, in this first embodiment, neither an amplifier circuit nor a buffer is provided between the nuclear magnetic resonance sensing part 1 and the digitizing device 21. That is, since only a passive element is used in a circuit from the nuclear magnetic resonance sensing part 1 to the digitizing device 21, the generation of the thermal noise is suppressed.

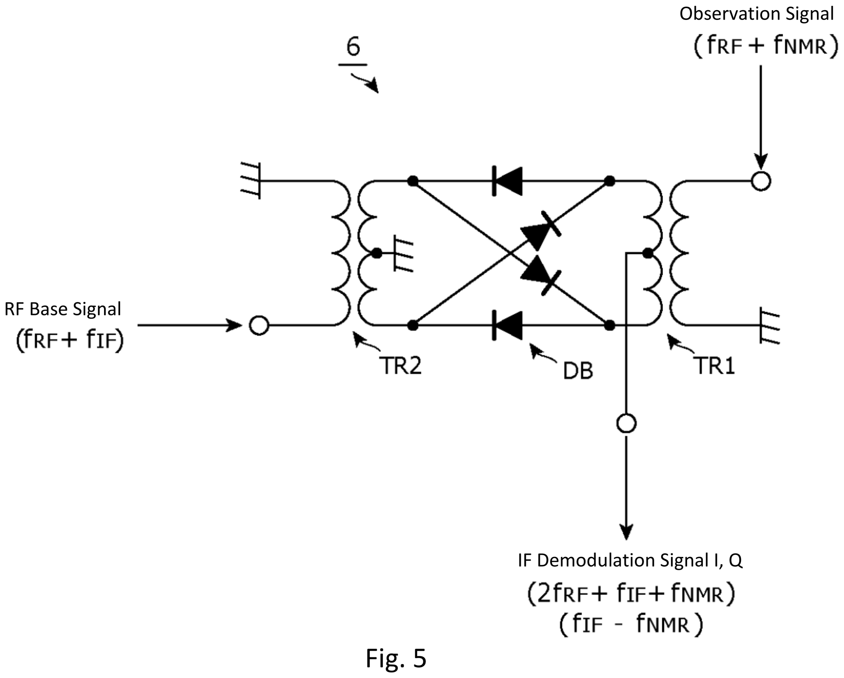

Fig. 5 is a circuit diagram that shows a configuration of the mixer part 6 in Fig. 1. As shown in, for instance, Fig. 5, the mixer part 6 is a Double Balanced Mixer (DBM) and has two phase distributors TR1 and TR2, and a diode bridge DB. In this embodiment, the phase distributors TR1 and TR2 are transformers. Further, the turn ratios of the phase distributors TR1 and TR2 are set so that an output impedance of the double balanced mixer exceeds a characteristic impedance of a cable connected to an input terminal of the DBM. Further, the turn ratio of the phase distributor TR1 and the turn ratio of the phase distributor TR2 are set to be the same.

A typical DBM is designed so that an output impedance of the DBM is a characteristic impedance of a cable (usually 50 ohms) connected to an output terminal of the DBM in order to have an impedance matching with respect to the characteristic impedance of the cable. However, when the IF demodulation signal is within a frequency band that does not require the impedance matching, there is no need to match the output impedance of the DBM to the characteristic impedance of the cable, various cables can be selected to be connected to the output terminal, and the characteristic impedance of the cable can also be various values. On the other hand, since the frequency bands of the observation signal and the RF base signal are in a frequency band that requires the impedance matching, the cable connected to the input terminal is usually a cable for such the frequency band that requires the impedance matching, and has a general characteristic impedance value (50 ohms). In this embodiment, in order to reduce a conduction current of the diode bridge DB and reduce the thermal noise of the diode bridge DB (diode), the number of turns of the winding of each part of the phase distributors TR1 and TR2 that is on a side of the diode bridge DB is increased. As a result, as mentioned above, the output impedance of the DBM exceeds the characteristic impedance (here, 50 ohms) of the cable connected to the input terminal.

Further, a resistance value (of a circuit including the wiring) from the nuclear magnetic resonance sensing part 1 to the mixer part 6 is equal to or less than an equivalent series resistance value Rs of the diodes in the diode bridge DB. Since the thermal noise of the diode is proportional to the equivalent series resistance value Rs, the thermal noise due to the resistance components from the nuclear magnetic resonance sensing part 1 to the mixer part 6 is equal to or less than the thermal noise of the diode. Therefore, as a result, the influence of the thermal noise caused by the resistance components from the nuclear magnetic resonance sensing part 1 to the mixer part 6 on the IF demodulation signal is less likely to appear.

Furthermore, a resistance value (of a circuit including the wiring) from the mixer part 6 to the digitizing device 21 is equal to or less than an equivalent series resistance value Rs of the diodes in the diode bridge DB. Since the thermal noise of the diode is proportional to the equivalent series resistance value Rs, the thermal noise due to the resistance components from the mixer part 6 to the digitizing device 21 is equal to or less than the thermal noise of the diode. Therefore, as a result, the influence of the thermal noise caused by the resistance components from the mixer part 6 to the digitizing device 21 on the IF demodulation signal is less likely to appear.

Furthermore, in this embodiment, the nuclear magnetic resonance sensing device shown in Fig. 1 has the transformer 9 at the preceding stage of the digitizing device 21.

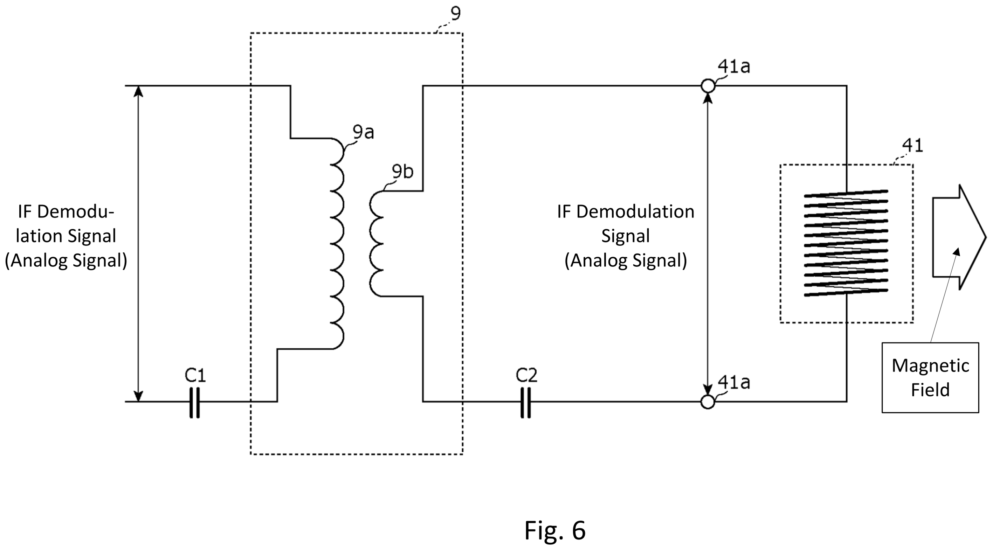

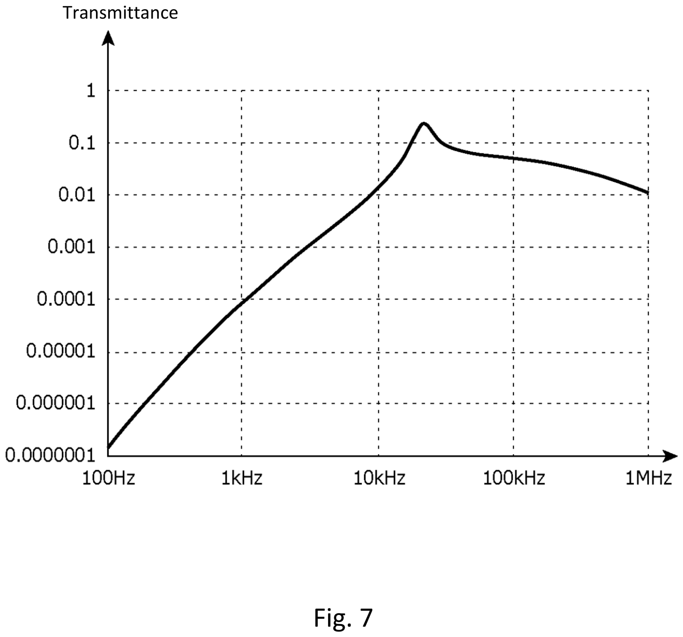

Fig. 6 is a circuit diagram that shows a configuration of the transformer 9 in Fig. 2. Fig. 7 is a diagram that explains an example of a band-pass filter characteristic of the transformer 9 shown in Fig. 6. The number of turns of a primary winding 9a of the transformer 9 is greater than the number of turns of a secondary winding 9b of the transformer 9. As a result, since a conduction current on the secondary side of the transformer 9 (i.e., a current being supplied to the physical field generator 41 (for instance, a coil) of the digitizing device 21) increases and the strength of a physical field (a magnetic field) being generated by the physical field generator 41 increases, an S/N ratio becomes better and sensitivity is improved.

Further, the transformer 9 has a band-pass filter characteristic shown in, for instance, Fig. 7. In this band-pass filter characteristic, the transmittance at the local oscillation frequency in IF demodulation (here, f_{RF} + f_{IF}) and the transmittance at the frequency f_{NMR} of the nuclear magnetic resonance signal are lower as compared with the transmittance at the frequency f_{IF} of the IF demodulation signal.

When the frequency f_{IF} of the IF demodulation signal is within a range of approximately 5 to 20 kHz, the component of the local oscillation frequency (here, f_{RF} + f_{IF}) contained in the IF demodulation signal and the component of the frequency f_{NMR} of the nuclear magnetic resonance signal are greatly attenuated by the transformer 9 having the band-pass filter characteristics shown in Fig. 7. As a result, the S/N ratio becomes better.

Furthermore, at least one of the primary side and the secondary side of the transformer 9 (here, both sides) is provided with a capacitor C1 and/or C2. As a result, the impedance (the primary side impedance and the secondary side impedance) of the transformer 9 at the frequency f_{IF} of the IF demodulation signal (as compared with a case in which the capacitors C1 and C2 are not provided) is reduced. Further, the capacitor C1 has an electrostatic capacity so that a resonance frequency between the capacitor C1 and the primary winding 9a is substantially coincident with the frequency f_{IF} of the IF demodulation signal. The capacitor C2 has an electrostatic capacity so that a resonance frequency between the capacitor C2 and the secondary winding 9b is substantially coincident with the frequency f_{IF} of the IF demodulation signal. Therefore, since the conduction current on the secondary side of the transformer 9 (i.e., the current being supplied to the physical field generator 41 of the digitizing device 21) increases, the strength of the physical field being generated by the physical field generator 41 increases. As a result, the S/N ratio becomes better.

Next, operations of the nuclear magnetic resonance sensing device according to the first embodiment will be explained.

The control device 22 controls the nuclear magnetic resonance sensing part 1, and at the same time, controls the switching part 4. The control device 22 applies a high frequency magnetic field based on the RF signal from the transmission system to the target object 101 in the nuclear magnetic resonance sensing part 1. The control device 22 controls the switching part 4 so as to conduct the observation signal from the nuclear magnetic resonance sensing part 1 to the reception system.

In addition, the control device 22 alternately inputs the RF base signal that is not phase-shifted by 90 degrees and the RF base signal that is phase-shifted by 90 degrees to the mixer part 6 at each measurement sequence in synchronization with successive measurement sequences in the sensor body 51.

As shown in Fig. 1, the observation signal is converted into the IF demodulation signal having a phase corresponding to each measurement sequence by the mixer part 6. Further, the IF demodulation signal from which the component on the side of the high frequency band is removed by the low-pass filter 7 is input to the digitizing device 21.

In the digitizing device 21, when the IF demodulation signal is applied to the physical field generator 41, a magnetic field with an intensity corresponding to the level of the input signal is generated in the physical field generator 41 and is applied to the sensor body 51 of the optical quantum sensor part 42.

In the sensor body 51, the measurement sequence is executed as mentioned above, and the light having a light quantity corresponding to the strength of the magnetic field is generated. In the first embodiment, according to the ODMR, the magnetic resonance member 61 generates the light having the light quantity corresponding to the strength of the magnetic field.

Thereafter, the photoelectric element 52 receives the light, generates the sensor signal having the level corresponding to the light quantity of the received light, and outputs the sensor signal to the A/D converter 43.

The A/D converter 43 digitizes the sensor signal, generates the digital IF demodulation signal corresponding to the analog IF demodulation signal, and outputs the digital IF demodulation signal to the control device 22.

The control device 22 continuously and repeatedly acquires the value of the digital IF demodulation signal in a first phase (the digital I signal) and the value of the digital IF demodulation signal in a second phase (the digital Q signal) alternately, derives the NMR signal (specifically, for instance, f_{NMR}) by the signal processing of the digital I signal and the digital Q signal, and performs such as the molecular structure analysis or the imaging of the target object 101 based on the NMR signal.

In this signal processing, the digital I signal and the digital Q signal as the IF demodulation signals are demodulated into a demodulation signal I and a demodulated signal Q, a Fourier transform such as a FFT (Fast Fourier Transform) is performed with respect to each of the demodulation signal I and the demodulated signal Q, and the frequency components of each of the demodulation signal I and the demodulated signal Q are identified. As a result, for instance, the NMR signal (frequency component f_{NMR}) is extracted and a chemical shift is detected. As a result, the target nuclear magnetic resonance signal and the chemical shift are detected while being distinguished from each other based on the demodulation signal I and the demodulated signal Q by the analysis in the control device 203. Therefore, it becomes possible to accurately detect the low-level nuclear magnetic resonance signal and perform the high-resolution nuclear magnetic resonance sensing.

As mentioned above, according to the first embodiment, the nuclear magnetic resonance sensing part 1 applies the RF signal to the target object 101 and generates the observation signal having the frequency that is the sum of the frequency of the RF signal and the frequency of the nuclear magnetic resonance signal. The mixer part 6 performs the IF demodulation of the observation signal and generates the IF demodulation signal including the nuclear magnetic resonance signal. The low-pass filter 7 attenuates the high frequency band component among the two band components that are obtained by the IF demodulation of the IF demodulation signals and passes the low frequency band component among the two band components. The digitizing device 21 digitizes the IF demodulation signal that has been passed through the low-pass filter 7. In the digitizing device 21, the physical field generator 41 generates a magnetic field or an electric field corresponding to the intermediate frequency demodulation signal that has been passed through the low-pass filter 7. In the optical quantum sensor part 42, the sensing member generates the light corresponding to the magnetic field or the electric field, the photoelectric element converts the light into the electrical signal as the sensor signal, and the analog/digital converter 43 digitizes the sensor signal. This optical quantum sensor part 42 performs the quantum operation with respect to the above-mentioned sensing member and causes the sensing member to generate the light corresponding to the above-mentioned magnetic field or the above-mentioned electric field.

As a result, by using the physical field generator 41 and the optical magnetic sensor part 42, a relatively high-level sensor signal corresponding to a weak IF demodulation signal is obtained and digitized. As a result, the IF demodulation signal (digital signal) including the NMR signal can be accurately obtained. Therefore, a minute IF demodulation signal with a level that is similar to or lower than the noise level of the A/D converter 43 is accurately digitized. In addition, it becomes possible to accurately detect the low-level NMR signal and perform the high-resolution nuclear magnetic resonance sensing.

### SECOND EMBODIMENT

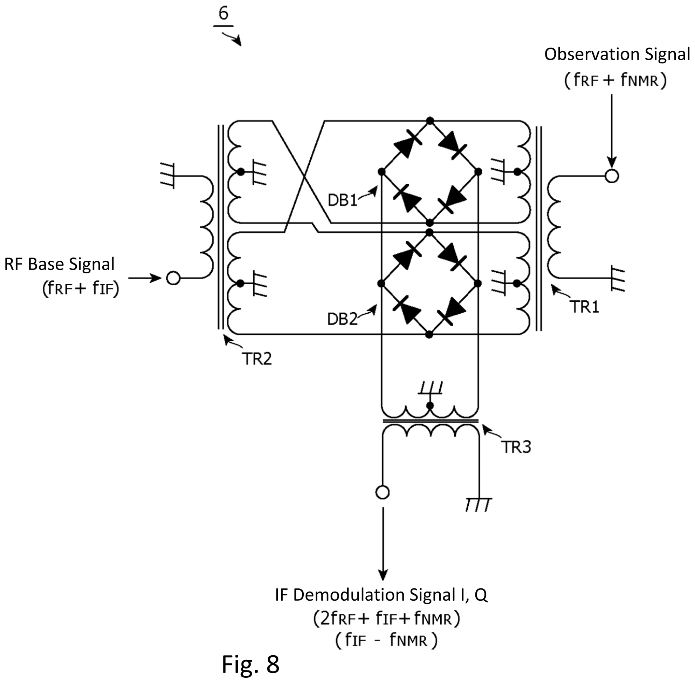

Fig. 8 is a circuit diagram that shows a configuration of a mixer part 6 in a second embodiment.

In the second embodiment, as shown in, for instance, Fig. 8, the mixer part 6 is a Triple Balanced Mixer (TBM) and has three phase distributors TR1, TR2, and TR3, and two diode bridges DB1 and DB2. In this embodiment, the phase distributors TR1, TR2, and TR3 are transformers. Further, the turn ratios of the phase distributors TR1, TR2, and TR3 are set so that a characteristic impedance of a primary side (including the diode bridges DB1 and DB2) of the phase distributor TR3 (output stage transformer) in the triple balanced mixer exceeds a characteristic impedance of a cable connected to an input terminal of the TBM. Further, the turn ratio of the phase distributor TR1, the turn ratio of the phase distributor TR2, and the turn ratio of the phase distributor TR3 are set to be the same.

A typical TBM is designed so that a primary-side characteristic impedance of the phase distributor TR3 in the TBM is a characteristic impedance of a cable connected to an output terminal of the TBM (usually 50 ohms) in order to have an impedance matching with respect to the characteristic impedance of the cable. However, when the IF demodulation signal is within a frequency band that does not require the impedance matching, there is no need to match the primary-side characteristic impedance of the above-mentioned phase distributor TR3 to the characteristic impedance of the cable, various cables can be selected to be connected to the output terminal, and the characteristic impedance of the cable can also be various values. On the other hand, since the frequency bands of the observation signal and the RF base signal are in a frequency band that requires the impedance matching, the cable connected to the input terminal is usually a cable for such the frequency band that requires the impedance matching, and has a general characteristic impedance value (50 ohms). In this embodiment, in order to reduce a conduction current of the diode bridges DB1 and DB2, and reduce the thermal noise of the diode bridges DB1 and DB2 (diodes), the number of turns of the winding of each part of the phase distributors TR1, TR2, and TR3 that is on a side of the diode bridges DB1 and DB2 is increased. As a result, as mentioned above, the primary-side characteristic impedance of the phase distributor TR3 in the TBM exceeds the characteristic impedance (here, 50 ohms) of the cable connected to the input terminal.

Further, a resistance value (of a circuit including the wiring) from the nuclear magnetic resonance sensing part 1 to the mixer part 6 is equal to or less than an equivalent series resistance value Rs of the diodes in the diode bridges DB1 and DB2. As a result, the influence of the thermal noise caused by the resistance components from the nuclear magnetic resonance sensing part 1 to the mixer part 6 on the IF demodulation signal is less likely to appear.

Furthermore, a resistance value (of a circuit including the wiring) from the mixer part 6 to the digitizing device 21 is equal to or less than an equivalent series resistance value Rs of the diodes in the diode bridges DB1 and DB2. As a result, the influence of the thermal noise caused by the resistance components from the mixer part 6 to the digitizing device 21 on the IF demodulation signal is less likely to appear.

Note that the other configurations and operations of the nuclear magnetic resonance sensing device according to the second embodiment are the same as those explained in the first embodiment. Therefore, the explanations of the other configurations and operations of the nuclear magnetic resonance sensing device according to the second embodiment will be omitted.

### THIRD EMBODIMENT

In the third embodiment, an optical quantum sensor part 42 performs a quantum operation with respect to a sensing member according to an optically pumped atomic magnetic force measuring method (OPAM) instead of the ODMR and causes the sensing member to generate light corresponding to a magnetic field.

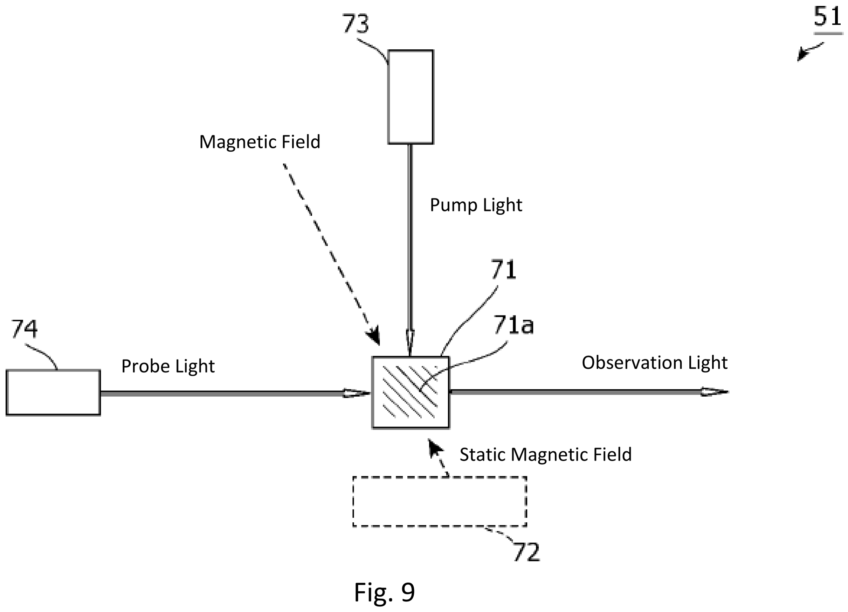

Fig. 9 is a diagram that shows a configuration of a sensor body 51 in a digitizing device according to a third embodiment. In the third embodiment, the sensor body 51 has a cell 71, a magnet 72, light emitting devices 73 and 74 for the OPAM.

The cell 71 is such as a transparent (permeable or transmissible) glass cell. Alkali metal atoms (for instance, K, Rb, and Cs) as a sensing member 71a are sealed along with buffer gas in the cell 71. The magnet 72 is a magnet that applies static magnetism to the sensing member and may be the above-mentioned permanent magnet or an electromagnet.

The light emitting device 73 generates pump light and irradiates the pump light to the sensing member 71a. The light emitting device 74 generates probe light and irradiates the probe light to the sensing member 71a. In an OPAM measurement sequence, a spin polarization is generated in the sensing member by optical pumping of the pump light and a rotation of the spin polarization corresponding to the magnetic field is measured by a magnetic optical rotation of the probe light. Specifically, a deflection rotation angle of an observation light (that is, the probe light after the magnetic optical rotation) is detected. The deflection rotation angle of the observation light is detected by a plurality of photoelectric elements 52 using such as a four-detector method. When the deflection rotation angle is detected by the plurality of photoelectric elements 52, an arithmetic processing (for instance, a difference calculation) may be performed after sensor signals are respectively digitized by a plurality of A/D converters 43 to become a plurality of digital signals.

Note that the other configurations and operations of the nuclear magnetic resonance sensing device according to the third embodiment are the same as those explained in the first embodiment or the second embodiment. Therefore, the explanations of the other configurations and operations of the nuclear magnetic resonance sensing device according to the third embodiment will be omitted.

### FOURTH EMBODIMENT

In a fourth embodiment, the physical field generator 41 generates an electric field corresponding to an input signal (that is, an analog IF demodulation signal) being input via the input terminal 41a of the physical field generator 41. The optical quantum sensor part 42 causes a sensing member in the sensor body 51 to generate light (observation light) corresponding to the electric field that is generated by the physical field generator 41 and causes the photoelectric element 52 to convert the light into an electrical signal as a sensor signal.

For instance, the physical field generator 41 generates the electric field using a pair of electrode plates. Further, this input signal may be an AC signal with a single frequency, an AC signal with a predetermined period having a plurality of frequency components, or a DC signal. That is, the above-mentioned electric field is, such as an AC electric field with a single frequency, an AC electric field with a predetermined period having a plurality of frequency components, or a DC electric field, according to the input signal.

Note that the other configurations and operations of the nuclear magnetic resonance sensing device according to the fourth embodiment are the same as those explained in any of the first, second, and third embodiments. Therefore, the explanations of the other configurations and operations of the nuclear magnetic resonance sensing device according to the fourth embodiment will be omitted. However, the sensing members being used in the ODMR and the OPAM are those in which a quantum state changes depending on the electric field and in which an electric field can be measured in the same or a similar measurement sequence.

Note that various changes and modifications to the embodiments described above will be apparent to one having ordinally skill in the art. Such the changes and modifications may be made without departing from the spirit and scope of the subject matter and without diminishing the intended advantages. That is, it is intended that such the changes and modifications are included within the scope of the claims.

For instance, in the first to fourth embodiments, the measurement method in the sensor bodies 51 is not limited to the above-mentioned ODMR and OPAM. As long as being a measurement method in which a quantum operation with respect a sensing member is performed by using the sensing member according to a physical field and it is capable of detecting observation light according to the physical field strength, any other measurement methods may be used.

Further, in the first to fourth embodiments, a predetermined arithmetic processing with respect to the output signals in the control device 22 may be performed so that the values (digital values) of the output signals of the digitizing devices 21 coincident with the levels of the analog IF demodulation signals.

Furthermore, in the first to fourth embodiments, as necessary, a low noise buffer (voltage amplification degree is equal to 1) that satisfies a noise level requirement may be provided at the next stage to the low-pass filter 7 or at the preceding stage of the digitizing devices 21.

In addition, in the first to fourth embodiments, the 90-degree phase shifter 8 and the phase switching parts 8a and 8b may not be provided, and the base signal generation device 2 may alternately generate an RF base signal that has been phase-shifted by 90 degrees and an RF base signal that is not phase-shifted by 90 degrees for each measurement sequence.

### INDUSTRIAL APPLICABILITY

The present invention can be applicable to, for instance, various measurements and imaging using nuclear magnetic resonance.

## Claims

1. A nuclear magnetic resonance sensing device comprising:
a nuclear magnetic resonance sensing part that applies a high frequency magnetic field based on an RF signal to a target object and generates an observation signal with a frequency that is shifted from a frequency of the RF signal by a frequency of a nuclear magnetic resonance signal;
a mixer part that performs intermediate frequency demodulation of the observation signal and generates an intermediate frequency demodulation signal including the nuclear magnetic resonance signal;
a low-pass filter that attenuates a high frequency component higher than an intermediate frequency of the intermediate frequency demodulation of the intermediate frequency demodulation signal and passes a frequency component of the nuclear magnetic resonance signal;
a digitizing device that digitizes the intermediate frequency demodulation signal that has passed through the low-pass filter; and
a transformer at a preceding stage of the digitizing device,
wherein the digitizing device includes:
a physical field generator that generates a magnetic field or an electric field corresponding to the intermediate frequency demodulation signal that has passed through the low-pass filter;
an optical quantum sensor part that generates light corresponding to the magnetic field or the electric field by a sensing member and converts the light into an electrical signal as a sensor signal by a photoelectric element; and
an analog/digital converter that digitizes the sensor signal,
the optical quantum sensor part performs a quantum operation with respect to the sensing member and causes the sensing member to generate the light corresponding to the magnetic field or the electric field, and
a number of turns of a primary winding of the transformer is larger than a number of turns of a secondary winding of the transformer.

2. The nuclear magnetic resonance sensing device according to claim 1,
wherein the transformer has a band-pass filter characteristic, and
in the band-pass filter characteristic, each of a transmittance at a local oscillation frequency in the intermediate frequency demodulation and a transmittance at the frequency of the nuclear magnetic resonance signal is lower as compared with a transmittance at a frequency of the intermediate frequency demodulation signal.

3. The nuclear magnetic resonance sensing device according to claim 1, further comprising:
a capacitor that reduces an impedance of the transformer at a frequency of the intermediate frequency demodulation signal,
wherein the capacitor is provided at at least one of a primary side and a secondary side of the transformer.

4. The nuclear magnetic resonance sensing device according to claim 1,
wherein the mixer part is configured with a double balanced mixer or a triple balanced mixer,
the double balanced mixer or the triple balanced mixer includes a plurality of phase distributors and a diode bridge, and
a turn ratio of the phase distributor is set so that an output impedance of the double balanced mixer or a characteristic impedance of a primary side of an output side transformer of the triple balanced mixer exceeds a characteristic impedance of a cable connected to an input terminal of the double balanced mixer or the triple balanced mixer.

5. The nuclear magnetic resonance sensing device according to claim 1,
wherein the mixer part is configured with a double balanced mixer or a triple balanced mixer,
the double balanced mixer or the triple balanced mixer includes a plurality of phase distributors and a diode bridge, and
a resistance value from the nuclear magnetic resonance sensing part to the mixer part is equal to or less than an equivalent series resistance value of a diode in the diode bridge.

6. The nuclear magnetic resonance sensing device according to claim 1,
wherein the mixer part is configured with a double balanced mixer or a triple balanced mixer,
the double balanced mixer or the triple balanced mixer includes a plurality of phase distributors and a diode bridge, and
a resistance value from the mixer part to the digitizing device is equal to or less than an equivalent series resistance value of a diode in the diode bridge.

7. The nuclear magnetic resonance sensing device according to claim 1, further comprising:
a control device,
wherein the optical quantum sensor part repeatedly and periodically executes predetermined measurement sequences, and performs the quantum operation with respect to the sensing member in each measurement sequence to cause the sensing member to generate the light corresponding to the magnetic field or the electric field, and
the control device alternatively switches a phase between two phases perpendicular to each other for each of the measurement sequences and causes the mixer part to generate the intermediate frequency demodulation signal with the two phases.

8. A nuclear magnetic resonance sensing device comprising:
a nuclear magnetic resonance sensing part that applies a high frequency magnetic field based on an RF signal to a target object and generates an observation signal with a frequency that is shifted from a frequency of the RF signal by a frequency of a nuclear magnetic resonance signal;
a mixer part that performs intermediate frequency demodulation of the observation signal and generates an intermediate frequency demodulation signal including the nuclear magnetic resonance signal;
a low-pass filter that attenuates a high frequency component higher than an intermediate frequency of the intermediate frequency demodulation of the intermediate frequency demodulation signal and passes a frequency component of the nuclear magnetic resonance signal; and
a digitizing device that digitizes the intermediate frequency demodulation signal that has passed through the low-pass filter,
wherein the digitizing device includes:
a physical field generator that generates a magnetic field or an electric field corresponding to the intermediate frequency demodulation signal that has passed through the low-pass filter;
an optical quantum sensor part that generates light corresponding to the magnetic field or the electric field by a sensing member and converts the light into an electrical signal as a sensor signal by a photoelectric element; and
an analog/digital converter that digitizes the sensor signal,
the optical quantum sensor part performs a quantum operation with respect to the sensing member and causes the sensing member to generate the light corresponding to the magnetic field or the electric field,
the mixer part is configured with a double balanced mixer or a triple balanced mixer,
the double balanced mixer or the triple balanced mixer includes a plurality of phase distributors and a diode bridge, and
a turn ratio of the phase distributor is set so that an output impedance of the double balanced mixer or a characteristic impedance of a primary side of an output side transformer of the triple balanced mixer exceeds a characteristic impedance of a cable connected to an input terminal of the double balanced mixer or the triple balanced mixer.

9. A nuclear magnetic resonance sensing device comprising:
a nuclear magnetic resonance sensing part that applies a high frequency magnetic field based on an RF signal to a target object and generates an observation signal with a frequency that is shifted from a frequency of the RF signal by a frequency of a nuclear magnetic resonance signal;
a mixer part that performs intermediate frequency demodulation of the observation signal and generates an intermediate frequency demodulation signal including the nuclear magnetic resonance signal;
a low-pass filter that attenuates a high frequency component higher than an intermediate frequency of the intermediate frequency demodulation of the intermediate frequency demodulation signal and passes a frequency component of the nuclear magnetic resonance signal; and
a digitizing device that digitizes the intermediate frequency demodulation signal that has passed through the low-pass filter,
wherein the digitizing device includes:
a physical field generator that generates a magnetic field or an electric field corresponding to the intermediate frequency demodulation signal that has passed through the low-pass filter;
an optical quantum sensor part that generates light corresponding to the magnetic field or the electric field by a sensing member and converts the light into an electrical signal as a sensor signal by a photoelectric element; and
an analog/digital converter that digitizes the sensor signal,
the optical quantum sensor part performs a quantum operation with respect to the sensing member and causes the sensing member to generate the light corresponding to the magnetic field or the electric field,
the mixer part is configured with a double balanced mixer or a triple balanced mixer,
the double balanced mixer or the triple balanced mixer includes a plurality of phase distributors and a diode bridge, and
a resistance value from the nuclear magnetic resonance sensing part to the mixer part is equal to or less than an equivalent series resistance value of a diode in the diode bridge.

10. A nuclear magnetic resonance sensing device comprising:
a nuclear magnetic resonance sensing part that applies a high frequency magnetic field based on an RF signal to a target object and generates an observation signal with a frequency that is shifted from a frequency of the RF signal by a frequency of a nuclear magnetic resonance signal;
a mixer part that performs intermediate frequency demodulation of the observation signal and generates an intermediate frequency demodulation signal including the nuclear magnetic resonance signal;
a low-pass filter that attenuates a high frequency component higher than an intermediate frequency of the intermediate frequency demodulation of the intermediate frequency demodulation signal and passes a frequency component of the nuclear magnetic resonance signal; and
a digitizing device that digitizes the intermediate frequency demodulation signal that has passed through the low-pass filter,
wherein the digitizing device includes:
a physical field generator that generates a magnetic field or an electric field corresponding to the intermediate frequency demodulation signal that has passed through the low-pass filter;
an optical quantum sensor part that generates light corresponding to the magnetic field or the electric field by a sensing member and converts the light into an electrical signal as a sensor signal by a photoelectric element; and
an analog/digital converter that digitizes the sensor signal,
the optical quantum sensor part performs a quantum operation with respect to the sensing member and causes the sensing member to generate the light corresponding to the magnetic field or the electric field,
the mixer part is configured with a double balanced mixer or a triple balanced mixer,
the double balanced mixer or the triple balanced mixer includes a plurality of phase distributors and a diode bridge, and
a resistance value from the mixer part to the digitizing device is equal to or less than an equivalent series resistance value of a diode in the diode bridge.

11. A nuclear magnetic resonance sensing device comprising:
a nuclear magnetic resonance sensing part that applies a high frequency magnetic field based on an RF signal to a target object and generates an observation signal with a frequency that is shifted from a frequency of the RF signal by a frequency of a nuclear magnetic resonance signal;
a mixer part that performs intermediate frequency demodulation of the observation signal and generates an intermediate frequency demodulation signal including the nuclear magnetic resonance signal;
a low-pass filter that attenuates a high frequency component higher than an intermediate frequency of the intermediate frequency demodulation of the intermediate frequency demodulation signal and passes a frequency component of the nuclear magnetic resonance signal;
a digitizing device that digitizes the intermediate frequency demodulation signal that has passed through the low-pass filter; and
a control device,
wherein the digitizing device includes:
a physical field generator that generates a magnetic field or an electric field corresponding to the intermediate frequency demodulation signal that has passed through the low-pass filter;
an optical quantum sensor part that generates light corresponding to the magnetic field or the electric field by a sensing member and converts the light into an electrical signal as a sensor signal by a photoelectric element; and
an analog/digital converter that digitizes the sensor signal,
the optical quantum sensor part repeatedly and periodically executes predetermined measurement sequences, and performs a quantum operation with respect to the sensing member in each measurement sequence to cause the sensing member to generate the light corresponding to the magnetic field or the electric field, and
the control device alternatively switches a phase between two phases perpendicular to each other for each of the measurement sequences and causes the mixer part to generate the intermediate frequency demodulation signal with the two phases.

12. A nuclear magnetic resonance sensing method comprising:
a step of applying a high frequency magnetic field based on an RF signal to a target object and generating an observation signal with a frequency that is shifted from a frequency of the RF signal by a frequency of a nuclear magnetic resonance signal;
a step of performing, by a mixer part, intermediate frequency demodulation of the observation signal and generating an intermediate frequency demodulation signal including the nuclear magnetic resonance signal;
a step of attenuating, by a low-pass filter, a high frequency component higher than an intermediate frequency of the intermediate frequency demodulation of the intermediate frequency demodulation signal and passing a frequency component of the nuclear magnetic resonance signal; and
a digitizing step of digitizing, by a digitizing device, the intermediate frequency demodulation signal that has passed through the low-pass filter,
wherein the digitizing step includes:
(a) generating a magnetic field or an electric field corresponding to the intermediate frequency demodulation signal that has passed through the low-pass filter;
(b) generating light corresponding to the magnetic field or the electric field by a sensing member;
(c) converting the light into an electrical signal as a sensor signal by a photoelectric element; and
(d) digitizing the sensor signal by an analog/digital converter, and
in the digitizing step, predetermined measurement sequences are repeatedly and periodically executed, and a quantum operation is performed with respect to the sensing member in each measurement sequence to cause the sensing member to generate the light corresponding to the magnetic field or the electric field, and
a phase is alternatively switched between two phases perpendicular to each other for each of the measurement sequences to cause the mixer part to generate the intermediate frequency demodulation signal with the two phases.
